# EUROPEAN PATENT APPLICATION

(11) **EP 4 415 024 A1**
(43) Date of publication of application: **14.08.2024**
(21) Application number: 22878361.9
(22) Date of filing: 26.09.2022
(51) Int. Cl.: H01L 21/20, H01L 21/205, H01L 29/78, H01L 29/12, H01L 21/336, C30B 29/36

(54) **METHOD FOR REDUCING STACKING FAULTS IN SILICON CARBIDE, AND STRUCTURE CREATED BY MEANS OF SAID METHOD**

(30) Priority: 05.10.2021 JP 2021164358
(71) Applicant: Kwansei Gakuin Educational Foundation, Nishinomiya-shi, Hyogo 662-8501 (JP); Toyota Tsusho Corporation, Nagoya-shi Aichi 450-8575 (JP)
(72) Inventor: KANEKO, Tadaaki, Sanda-shi, Hyogo 669-1337 (JP); DOJIMA, Daichi, Sanda-shi, Hyogo 669-1337 (JP); TODA, Kohei, Sanda-shi, Hyogo 669-1337 (JP); SASAKI, Jun, Sanda-shi, Hyogo 669-1337 (JP); KOJIMA, Kiyoshi, Tokyo 108-8208 (JP)
(74) Representative: Schön, Christoph
(86) International application number: PCT/JP2022/035760
(87) International publication number: WO 2023/058491

(57) **Abstract**

An object of the present invention is to provide a novel technique for reducing stacking faults SF in silicon carbide. Another object of the present invention is to provide a novel technique capable of reducing the stacking faults SF under a small number of growth conditions.

The present invention is a method for reducing stacking faults in silicon carbide including a growth step S10 of growing an epitaxial layer 20 on a bulk layer 10 of silicon carbide having stacking faults SF under a SiC-C equilibrium vapor pressure environment.

## Description

### Technical Field

The present invention relates to a method for reducing stacking faults in silicon carbide and a structure produced by the method.

### Background Art

Comparing to silicon (Si), silicon carbide (SiC) has a dielectric breakdown field that is one order of magnitude larger, a band gap that is three times larger, and a thermal conductivity that is about three times higher. Therefore, the silicon carbide is expected to be applied to power devices, high frequency devices, high temperature operation devices, and the like.

In order to improve reliability of a semiconductor device using silicon carbide, it is necessary to suppress density of various crystal defects and stacking faults (SF) in an epitaxial layer as much as possible.

In particular, the stacking faults are regarded as a cause of voltage abnormality in the power device, and a technique for forming an epitaxial layer having few stacking faults has been proposed.

For example, Patent Literature 1 describes a technique of "A silicon carbide epitaxial growth method for forming a doped silicon carbide single-crystal thin film on a silicon surface of a silicon carbide single-crystal substrate in a reaction vessel by a thermal CVD method through supplying a hydrocarbon source gas, a silicon source gas, and a doping gas, wherein when the silicon carbide single-crystal thin film is formed, a C/Si ratio that is a ratio of C contained in a hydrocarbon source gas to Si contained in a silicon source gas is changed at least three times as growth conditions, and the C/Si ratio is increased stepwise every time the C/Si ratio is changed so that density of stacking faults on a surface of the silicon carbide single-crystal thin film is 10 faults/cm² or less and double Shockley stacking faults are 5 faults/cm² or less".

By the way, the inventors of the present application have developed a growth method different from the thermal CVD method and filed patent applications for a purpose of reducing basal plane dislocation (BPD) in the epitaxial layer. For example, Patent Literature 2 describes a technique of "reducing BPD density in a growth layer by including an epitaxial growth step of growing a SiC substrate under a SiC-C equilibrium vapor pressure environment".

### Citation List

### Patent Literature

Patent Literature 1: JP 2018-162178 A
Patent Literature 2: WO 2020/095872 A

### Summary of Invention

### Technical Problem

An object of the present invention is to provide a novel technique for reducing stacking faults in silicon carbide.

In addition, an object of the present invention is to provide a novel technique capable of reducing stacking faults with a small number of steps (growth conditions).

### Solution to Problem

The present invention to solve the above-described problems is a method for reducing stacking faults in silicon carbide, including a growth step of growing an epitaxial layer on a bulk layer having stacking faults under a SiC-C equilibrium vapor pressure environment.

In a preferred mode of the present invention, the growth step includes a first growth step of growing a first epitaxial layer under the SiC-C equilibrium vapor pressure environment, and a second growth step of growing a second epitaxial layer on the first epitaxial layer.

In a preferred mode of the present invention, the growth step is a step of growing the epitaxial layer having a density of the stacking faults of 5.0 faults/cm² or less.

In a preferred mode of the present invention, the growth step is a step of growing the epitaxial layer having a density of the stacking faults of 3.0 faults/cm² or less.

In a preferred mode of the present invention, the growth step is a step of growing the epitaxial layer having a density of the stacking faults of 1.0 faults/cm² or less.

In a preferred mode of the present invention, the growth step is a step of growing the epitaxial layer on the bulk layer having a diameter of at least 4 inches or more.

The present invention also relates to a method for manufacturing a silicon carbide substrate. In other words, the present invention for solving the above-described problems is a method for manufacturing a silicon carbide substrate including a growth step of growing an epitaxial layer on a bulk layer having stacking faults under a SiC-C equilibrium vapor pressure environment.

The present invention also relates to a silicon carbide substrate. In other words, the present invention for solving the above-described problems is a silicon carbide substrate including a single epitaxial layer in which stacking faults are converted into crystal defects other than the stacking faults, in which the epitaxial layer has a density of stacking faults of 5.0 faults/cm² or less.

In addition, the present invention to solve the above-described problems is a silicon carbide substrate including: a first epitaxial layer in which stacking faults are converted into crystal defects other than the stacking faults; and a second epitaxial layer grown on the first epitaxial layer, in which a density of stacking faults of the second epitaxial layer is 5.0 faults/cm² or less.

In a preferred mode of the present invention, the density of the stacking faults is 3.0 faults/cm² or less.

In a preferred mode of the present invention, the density of the stacking faults is 1.0 faults/cm² or less.

In a preferred mode of the invention, it has a diameter of at least 4 inches or more.

The present invention also relates to a method for manufacturing a silicon carbide semiconductor device. In other words, the present invention for solving the above-described problems is a method for manufacturing a silicon carbide semiconductor device, the method including: a growth step of growing an epitaxial layer on a bulk layer having stacking faults under a SiC-C equilibrium vapor pressure environment; and a device formation step of forming a device region in at least a part of a substrate having the epitaxial layer.

The present invention also relates to a silicon carbide semiconductor device. In other words, the present invention for solving the above-described problems is a silicon carbide semiconductor device including: one epitaxial layer in which stacking faults are converted into crystal defects other than the stacking faults; and a device region formed in the epitaxial layer, in which a density of stacking faults of the epitaxial layer is 5.0 faults/cm² or less.

In addition, the present invention for solving the above-described problems is a silicon carbide semiconductor device including: a first epitaxial layer in which stacking faults are converted into crystal defects other than the stacking faults; a second epitaxial layer having a doping concentration lower than that of the bulk layer; and a device region formed in the second epitaxial layer, in which a density of the stacking faults of the second epitaxial layer is 5.0 faults/cm² or less.

In a preferred mode of the present invention, the density of the stacking faults is 3.0 faults/cm² or less.

In a preferred mode of the present invention, the density of the stacking faults is 1.0 faults/cm² or less. Advantageous Effects of Invention

According to the disclosed technique, it is possible to provide a novel technique for reducing the stacking faults in silicon carbide.

In addition, according to the disclosed technique, it is an object of the present invention to provide a novel technique capable of reducing the stacking faults under a small number of growth conditions.

Other problems, features and advantages will become apparent from a reading of the following detailed description when taken in conjunction with the drawings and claims.

### Brief Description of Drawings

Fig. 1 is an explanatory view for explaining a method for growing silicon carbide according to an embodiment.
Fig. 2 is an explanatory view for explaining the method for growing silicon carbide according to the embodiment.
Fig. 3 is an explanatory view for explaining a method for growing silicon carbide according to another embodiment.
Fig. 4 is an explanatory view for explaining a method for manufacturing a silicon carbide semiconductor device according to an embodiment.
Fig. 5 is an explanatory view for explaining a method for manufacturing a silicon carbide semiconductor device according to another embodiment.
Fig. 6 is a graph showing the density of stacking faults in Examples and Comparative Examples.

### Description of Embodiments

Hereinafter, preferred embodiments of a method for reducing stacking faults in silicon carbide according to the present invention and a structure produced by the method will be described in detail with reference to the accompanying drawings. The technical scope of the present invention is not limited to the embodiments illustrated in the accompanying drawings, and can be appropriately changed within the scope described in the claims. In the present description and the accompanying drawings, in a layer or a region denoted with n or p, it means that electrons or holes are majority carriers, respectively. In addition, + and - added to n and p mean a higher impurity concentration and a lower impurity concentration than a layer and a region to which + and - are not added, respectively. In a case where notations of n and p including + and - are the same, it indicates that the concentrations are close, and the concentrations are not necessarily equal. In addition, in the present description, in the notation of the Miller indices, "-" means a bar attached to the index immediately after it, and "-" is added in front of the index to express a negative index. In the following description of the embodiments and the accompanying drawings, the same reference numerals are given to the same configurations, and redundant description is omitted.

### <<Method for reducing stacking faults in silicon carbide>>

A method for reducing stacking faults in silicon carbide according to the present invention includes a growth step S10 of growing an epitaxial layer 20 on a bulk layer 10 of silicon carbide having stacking faults SF under a SiC-C equilibrium vapor pressure environment.

In the present invention, by including the growth step S10 of growing the epitaxial layer 20 under the SiC-C equilibrium vapor pressure environment, the stacking faults SF present in the bulk layer 10 can be converted into crystal defects other than the stacking faults SF, and the epitaxial layer 20 in which the stacking faults SF are reduced can be grown.

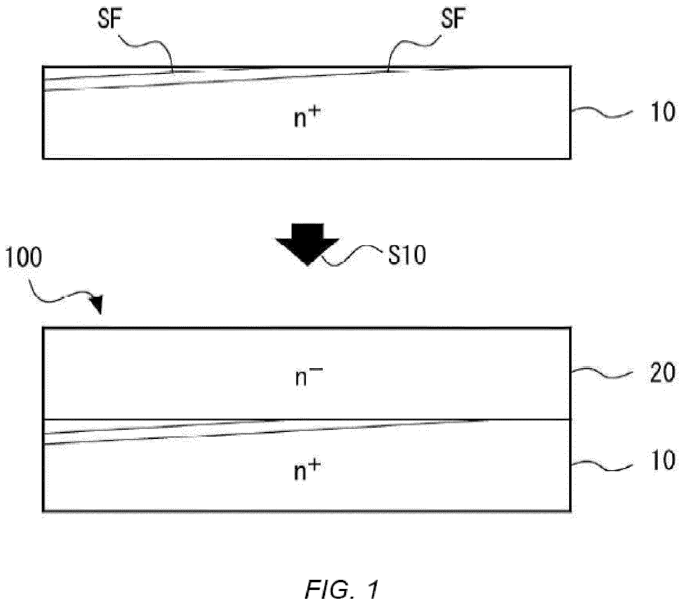

Fig. 1 is the explanatory view for explaining an embodiment of a method for reducing the stacking faults in silicon carbide.

The method for reducing the stacking faults in silicon carbide according to the present embodiments includes the growth step S10 of growing one epitaxial layer 20 in which the stacking faults SF are reduced on the bulk layer 10 having the stacking faults SF. The growth step S10 includes a step of growing the epitaxial layer 20 under the SiC-C equilibrium vapor pressure environment. In the growth step S10 in the embodiment, the n⁻ type epitaxial layer 20 having a doping concentration lower than that of the n⁺ type bulk layer 10 is grown.

### <Growth step S10>

Hereinafter, the growth conditions of the growth step S10 according to the present invention will be described in detail.

### (SiC-C equilibrium vapor pressure environment)

The "SiC-C equilibrium vapor pressure environment" in the present description refers to an environment of vapor pressure when SiC (a solid phase) and C (a solid phase) are in a phase equilibrium state through a gas phase. This SiC-C equilibrium vapor pressure environment can be formed by heat-treating a quasi-closed space having an atomic ratio Si/C of 1 or less. As a method for realizing the SiC-C equilibrium vapor pressure environment, for example, a manufacturing apparatus and growth conditions described in Patent Literature 2 can be adopted.

Specifically, when a SiC substrate satisfying a stoichiometric ratio of 1:1 is disposed in a SiC container satisfying the stoichiometric ratio of 1:1, the atomic ratio Si/C in the container is 1. Further, a C vapor supply source (a C pellet or the like) may be disposed to set the atomic ratio Si/C to 1 or less. By heating the container disposed so that the atomic ratio Si/C in the container is 1 or less in this manner, the SiC-C equilibrium vapor pressure environment can be formed in the container.

The SiC-C equilibrium vapor pressure environment in the present description includes a near-thermal equilibrium vapor pressure environment that satisfies a relationship between a growth rate and a growth temperature derived from a theoretical thermal equilibrium environment.

In addition, the "quasi-closed space" in the present description refers to a space in which inside of the container can be evacuated but at least a part of vapor generated in the container can be confined. This quasi-closed space can be formed in the container.

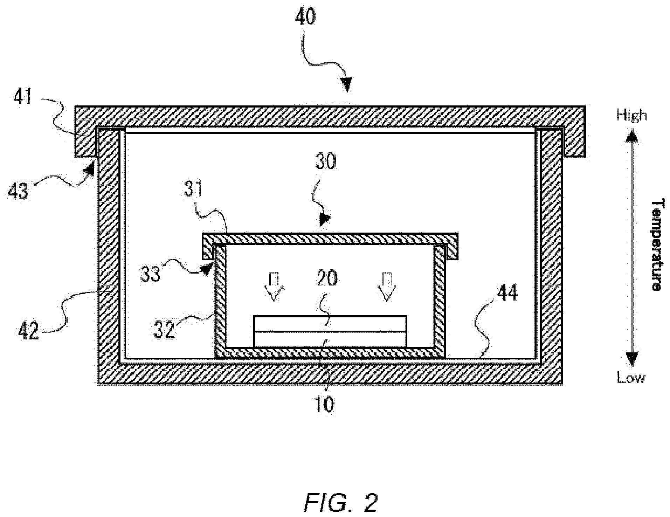

Fig. 2 is the explanatory view for explaining how the epitaxial layer 20 is grown using a manufacturing apparatus adopted in the method for growing silicon carbide according to the embodiment. A manufacturing apparatus that realizes the SiC-C equilibrium vapor pressure environment includes a main container 30 that accommodates a base substrate (the bulk layer 10) and a refractory material container 40 that accommodates the main container 30.

In a state where the base substrate (the bulk layer 10) is accommodated in the main container 30 and the main container 30 is accommodated in the refractory material container 40, by heating with a temperature gradient so that the temperature of a base substrate side becomes low, atoms are supplied from a part of the main container 30 on a high temperature side to the base substrate, and the epitaxial layer 20 is formed.

### (Bulk layer 10)

The bulk layer 10 includes a silicon carbide wafer obtained by slicing an ingot produced by a sublimation method or the like into a disk shape, or a substrate obtained by processing a single-crystal SiC into a thin plate shape. As a crystal polymorph of the single-crystal SiC, any polytype can be adopted.

The bulk layer 10 has the stacking faults SF on the surface. Presence or absence and the density of stacking faults SF can be confirmed by a known method used for detecting stacking faults SF, such as a photoluminescence (PL) method, transmission or reflection X-ray topography (XRT), dislocation evaluation by chemical etching, or Raman spectroscopy.

When the stacking faults SF are taken over from the bulk layer 10 to the epitaxial layer 20, problems such as (1) generating an interface state under a gate oxide film in a SiC-MOSFET to destabilize a gate threshold voltage, (2) causing bipolar degradation in a SiC-MOSFET and a PIN diode, (3) increasing an on-resistance in a SiC-MOSFET, and (4) generating a leakage current between a drain and a source (DS) in a SiC-MOSFET may occur.

The dopant added to the bulk layer 10 may be an element generally doped in a silicon carbide substrate. Specifically, nitrogen (N), phosphorus (P), aluminum (Al), boron (B), and the like can be exemplified. In the embodiment, a case where nitrogen or phosphorus that makes the bulk layer 10 n-type is employed is illustrated, but aluminum or boron that makes the bulk layer 10 p-type may be employed.

A doping concentration of the bulk layer 10 is preferably higher than 1 × 10¹⁷ cm⁻³, more preferably 1 × 10¹⁸ cm⁻³ or more, and still more preferably 1 × 10¹⁹ cm⁻³ or more. The dopant and the doping concentration can be confirmed by the Raman spectroscopy or secondary ion mass spectrometry (SIMS).

The diameter of the bulk layer 10 is preferably 4 inches or more, more preferably 6 inches or more, and still more preferably 8 inches or more.

### (Epitaxial layer 20)

The epitaxial layer 20 is a layer that reduces the density of stacking faults SF by converting the stacking faults SF present on a surface of the bulk layer 10 into the crystal defects other than the stacking faults SF.

In the epitaxial layer 20, a conversion rate at which the stacking faults SF are converted the into crystal defects other than the stacking faults SF is preferably 50% or more, more preferably 60% or more, still more preferably 70% or more, further more preferably 80% or more, and particularly more preferably 90% or more.

The density of stacking faults SF of the epitaxial layer 20 is preferably 5.0 faults/cm² or less, more preferably 3.0 faults/cm² or less, and still more preferably 1.0 faults/cm² or less.

The doping concentration of the epitaxial layer 20 is preferably lower than 1 × 10¹⁷ cm⁻³, more preferably 1 × 10¹⁶ cm⁻³ or less, and still more preferably 1 × 10¹⁵ cm⁻³ or less.

### (Main container 30)

The main container 30 may be configured to accommodate the base substrate (the bulk layer 10) and generate vapor pressures of a vapor phase species containing a Si element and a vapor phase species containing a C element in an internal space during heat treatment. For example, the main container 30 is made of a material containing polycrystalline SiC. In the embodiments illustrated in Fig. 2, the entire main container 30 is made of the polycrystalline SiC. By heating the main container 30 made of such a material, the vapor pressures of the vapor phase species containing the Si element and the vapor phase species containing the C element can be generated.

In other words, it is desirable that the environment in the heat-treated main container 30 be a vapor pressure environment of a mixed system of the vapor phase species containing the Si element and the vapor phase species containing the C element. Examples of the vapor phase species containing the Si element include Si, Si₂, Si₃, Si₂C, SiC₂, and SiC. Examples of the vapor phase species containing the C element include Si₂C, SiC₂, SiC, and C. In other words, the SiC-based gas is present in the main container 30.

The dopant and doping concentration of the main container 30 can be selected for a desired dopant and the doping concentration of the epitaxial layer 20. For example, by adopting the polycrystalline SiC having a doping concentration lower than that of the bulk layer 10 as a material of the main container 30, the epitaxial layer 20 having a doping concentration lower than that of the bulk layer 10 can be grown.

Note that the structure can be adopted as long as the vapor pressure of the vapor phase species containing the Si element and the vapor phase species containing the C element is generated in the internal space during the heating treatment of the main container 30. For example, a configuration in which the polycrystalline SiC is exposed on a part of an inner surface, a configuration in which the polycrystalline SiC is separately disposed in the main container 30, and the like can be shown.

As illustrated in Fig. 2, the main container 30 is a fitting container including an upper container 31 and a lower container 32 that can be fitted to each other. A minute gap 33 is formed in a fitting portion between the upper container 31 and the lower container 32, and inside of the main container 30 can be exhausted (evacuated) from the gap 33.

The growth step S10 is a step of transporting Si atoms and C atoms of the main container 30 to a surface of the bulk layer 10 using a temperature difference between the bulk layer 10 and the main container 30 as a driving force. In other words, at least a part (for example, a top surface of the upper container 31) of the main container 30 becomes higher in temperature than the bulk layer 10 due to a temperature gradient formed by a heating furnace, thereby generating the driving force for transporting the source to the bulk layer 10.

Specifically, when the temperature of the surface of the bulk layer 10 is compared with the temperature of the top surface of the upper container 31 facing the bulk layer 10, heating is performed such that the temperature on the bulk layer 10 side is low and the temperature on the upper container 31 side is high. As described above, by forming a space with the temperature difference between the bulk layer 10 and the upper container 31 in the main container 30, Si atoms and C atoms of the upper container 31 can be transported to the bulk layer 10 using the temperature difference as the driving force.

### (Refractory material container 40)

The refractory material container 40 contains a high-melting point material. For example, C which is a general-purpose heat-resistant member, W, Re, Os, Ta, and Mo which are high-melting point metals, Ta₉C₈, HfC, TaC, NbC, ZrC, Ta₂C, TiC, WC, and MoC which are carbides, HfN, TaN, BN, Ta₂N, ZrN, and TiN which are nitrides, HfB₂, TaB₂, ZrB₂, NB₂, TiB₂ which are borides, polycrystalline SiC, and the like can be exemplified.

Similarly to the main container 30, the refractory material container 40 is a fitting container including an upper container 41 and a lower container 42 that can be fitted to each other, and is configured to be capable of accommodating the main container 30. A minute gap 43 is formed in the fitting portion between the upper container 41 and the lower container 42, and inside of the refractory material container 40 can be exhausted (evacuated) from the gap 43.

The refractory material container 40 includes a Si vapor supply source 44 capable of supplying vapor pressure of a vapor phase species containing Si element into the refractory material container 40. The Si vapor supply source 44 may be configured to generate Si vapor in the refractory material container 40 during the heat treatment, and examples thereof include solid Si (a Si pellet such as a single-crystal Si piece or Si powder) and a Si compound. For example, a layer obtained by silicidation of the high-melting point material may be provided inside the above-described refractory material container 40.

In addition, any configuration can be adopted as long as the vapor pressure of the vapor phase species containing the Si element is formed in the refractory material container 40 during the heat treatment.

According to the method for reducing the stacking faults of silicon carbide according to the embodiment, the epitaxial layer 20 in which the stacking faults SF are reduced can be grown by including the growth step S10 of growing the epitaxial layer 20 under the SiC-C equilibrium vapor pressure environment. In other words, the epitaxial layer 20 can be grown without taking over most of the stacking faults SF present in the bulk layer 10. According to the present embodiment, it is possible to obtain the epitaxial layer 20 of the silicon carbide in which the stacking faults SF are reduced in as few steps (the growth conditions) as one time.

The growth step S10 according to the present invention may include a step of growing at least one epitaxial layer 20 under the SiC-C equilibrium vapor pressure environment. Therefore, when the two epitaxial layers 20 are grown under different growth conditions, any one layer may be grown under the SiC-C equilibrium vapor pressure environment.

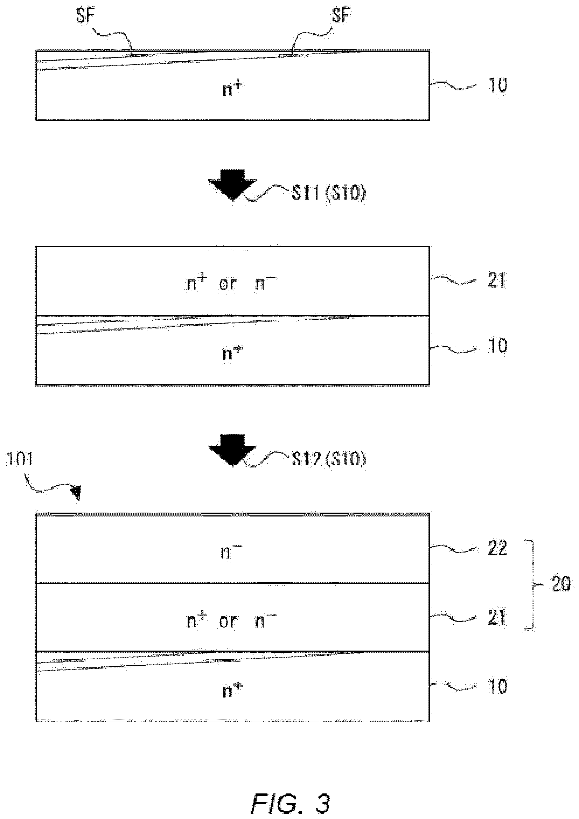

Fig. 3 is the explanatory view for explaining another embodiment of the method for reducing the stacking faults in silicon carbide. Note that constituent elements that are basically the same as the constituent elements described in the previous embodiments are denoted by the same reference numerals, and the description thereof will be simplified.

A method for reducing the stacking faults in silicon carbide according to another embodiment includes the growth step S10 of growing the epitaxial layer 20 with reduced stacking faults SF on the bulk layer 10 having the stacking faults SF, and the growth step S10 includes a first growth step S11 of growing a first epitaxial layer 21 under the SiC-C equilibrium vapor pressure environment, and a second growth step S12 of growing a second epitaxial layer 22 having a doping concentration lower than that of the bulk layer 10 on the first epitaxial layer 21.

In other words, as illustrated in Fig. 3, the epitaxial layer 20 of another embodiment includes the first epitaxial layer 21 in which the stacking faults SF is converted into the crystal defects other than the stacking faults SF, and an n⁻ type second epitaxial layer 22 having a doping concentration lower than that of the bulk layer 10.

In the first growth step S11, an n⁺ type first epitaxial layer 21 having a doping concentration equivalent to that of the n⁺ type bulk layer 10 may be grown, or an n⁻ type first epitaxial layer 21 having a doping concentration lower than that of the bulk layer 10 may be grown. In other words, the doping concentration of the first epitaxial layer 21 is preferably 1 × 10¹⁷ cm⁻³ or less, more preferably 1 × 10¹⁶ cm⁻³ or less, still more preferably 1 × 10¹⁵ cm⁻³ or less, or is preferably 1 × 10¹⁷ cm⁻³ or more, more preferably 1 × 10¹⁸ cm⁻³ or more, and still more preferably 1 × 10¹⁹ cm⁻³ or more. As a growth method for the first growth step S11, a method similar to that of the previous embodiments can be adopted.

The first epitaxial layer 21 is a layer that reduces the density of stacking faults SF by converting the stacking faults SF present on the surface of the bulk layer 10 into the crystal defects other than the stacking faults SF.

In the first epitaxial layer 21, conversion from the stacking faults SF to the crystal defects other than the stacking faults SF is preferably 50% or more, more preferably 60% or more, still more preferably 70% or more, further more preferably 80% or more, and particularly more preferably 90% or more.

The density of stacking faults SF of the first epitaxial layer 21 is preferably 5.0 faults/cm² or less, more preferably 3.0 faults/cm² or less, and still more preferably 1.0 faults/cm² or less.

In the second growth step S12, a growth method different from that in the previous first growth step S11 can be adopted. For example, a known film forming method such as a physical vapor deposition method (PVD method) or a chemical vapor deposition method (CVD method) may be adopted.

The second epitaxial layer 22 is grown on top of the first epitaxial layer 21 with reduced stacking faults SF. Therefore, the density of stacking faults SF of the second epitaxial layer 22 is preferably 5.0 faults/cm² or less, more preferably 3.0 faults/cm² or less, and still more preferably 1.0 faults/cm² or less.

The doping concentration of the second epitaxial layer 22 is preferably lower than 1 × 10¹⁷ cm⁻³, more preferably 1 × 10¹⁶ cm⁻³ or less, and still more preferably 1 × 10¹⁵ cm⁻³ or less.

According to another embodiment, the epitaxial layer 20 of silicon carbide in which the stacking faults SF are reduced can be obtained in as few steps (the growth conditions) as 2 steps.

### <<Silicon carbide substrate>>

The silicon carbide substrate according to the present invention is substrates 100 and 101 manufactured using the above-described method for reducing the stacking faults of silicon carbide, and includes the epitaxial layer 20 in which the stacking faults SF are converted into the crystal defects other than the stacking faults SF. Note that constituent elements that are basically the same as the constituent elements described in the previous embodiments are denoted by the same reference numerals, and the description thereof will be simplified.

As illustrated in Fig. 1, the substrate 100 according to the embodiment includes one epitaxial layer 20 obtained by converting the stacking faults SF in the bulk layer 10 into the crystal defects other than the stacking faults SF. The density of stacking faults SF of the epitaxial layer 20 is preferably 5.0 faults/cm² or less, more preferably 3.0 faults/cm² or less, and still more preferably 1.0 faults/cm² or less.

The diameter of the bulk layer 10 is preferably 4 inches or more, more preferably 6 inches or more, and still more preferably 8 inches or more.

As illustrated in Fig. 3, the silicon carbide substrate 101 according to another embodiment includes the first epitaxial layer 21 obtained by converting the stacking faults SF of the bulk layer 10 into the crystal defects other than the stacking faults SF, and the second epitaxial layer 22 having a doping concentration lower than that of the bulk layer 10 grown on the first epitaxial layer 21.

The density of stacking faults SF of the second epitaxial layer 22 is preferably 5.0 faults/cm² or less, more preferably 3.0 faults/cm² or less, and still more preferably 1.0 faults/cm² or less.

The diameter of the bulk layer 10 is preferably 4 inches or more, more preferably 6 inches or more, and still more preferably 8 inches or more.

### <<Method for manufacturing silicon carbide semiconductor device>>

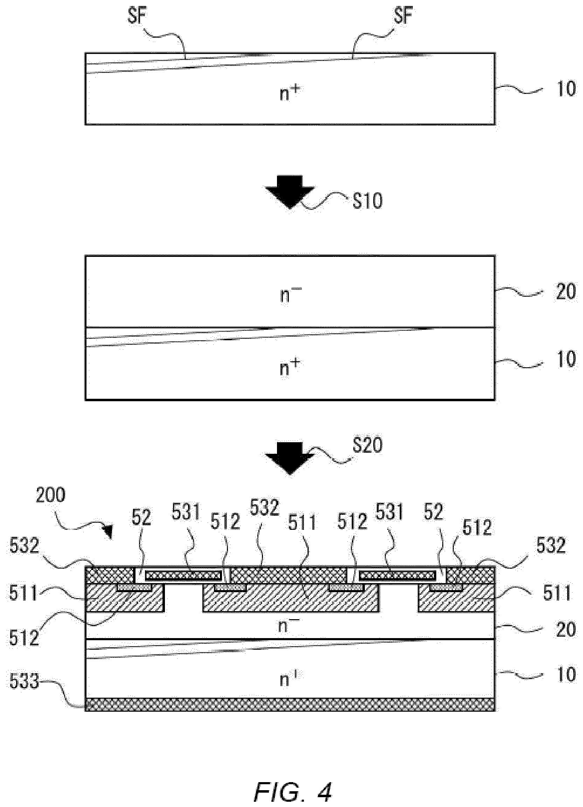

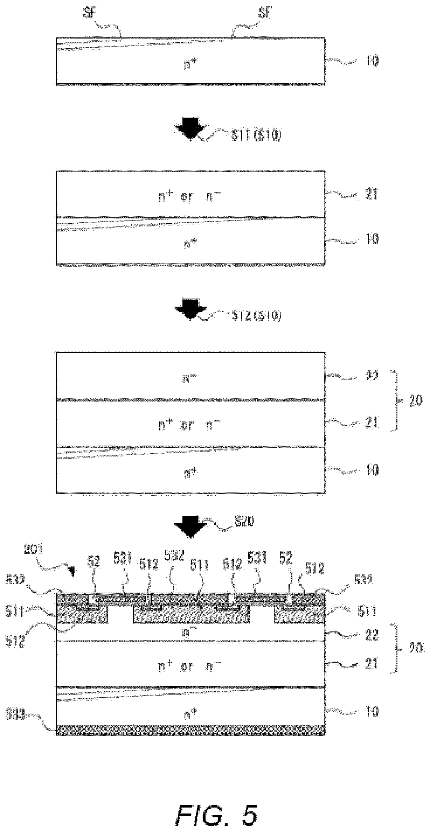

Fig. 4 is the explanatory view for explaining the method for manufacturing the silicon carbide semiconductor device according to the embodiment. Fig. 5 is the explanatory view for explaining the method for manufacturing the silicon carbide semiconductor device according to another embodiment. Note that constituent elements that are basically the same as the constituent elements described in the previous embodiments are denoted by the same reference numerals, and the description thereof will be simplified.

As illustrated in Fig. 4, the method for manufacturing the silicon carbide semiconductor device according to the embodiment includes the growth step S10 of growing the epitaxial layer 20 on the bulk layer 10 of silicon carbide having stacking faults SF under the SiC-C equilibrium vapor pressure environment, and a device formation step S20 of forming a device region 50 in at least a part of a substrate having the epitaxial layer 20.

In addition, as illustrated in Fig. 5, the method for manufacturing the silicon carbide semiconductor device according to another embodiment includes the first growth step S11 of growing the first epitaxial layer 21 under the SiC-C equilibrium vapor pressure environment, the second growth step S12 of growing the second epitaxial layer 22 having a doping concentration lower than that of the bulk layer 10 on the first epitaxial layer 21, and the device formation step S20 of forming the device region 50 in at least a part of a substrate having the first epitaxial layer 21.

Note that the device region 50 is a structure necessary for functioning as a semiconductor device, and includes at least a doping region 51, an insulating film 52, and an electrode 53.

### <Device formation step S20>

The device formation step S20 includes, for example, a patterning step S21 of forming a circuit pattern on the substrate having the epitaxial layer 20, a doping step S22 of introducing the doping region 51 into the substrate using this circuit pattern, an insulating film formation step S23 of forming the insulating film 52, and an electrode formation step S24 of forming the electrode 53.

The patterning step S21 can include, by way of example, a resist application step of applying a photoresist, an exposure step of exposing a photoresist through a photomask, a development step of developing the exposed photoresist, and a selective etching step of etching an exposed surface below the photoresist. Through these steps, a circuit pattern can be formed on the epitaxial layer 20.

The doping step S22 may include, for example, an ion implantation step of irradiating the substrate with dopant ions that are ionized dopant atoms, and an activation step of performing an activation treatment by heat-treating the substrate irradiated with the dopant ions.

This step is a step of forming the doping region 51 by repeating the patterning step S21 and the doping step S22. The doping region 51 includes, for example, one or more of an n-type or p-type well region 511, an n-type or p-type contact region 512, an n-type or p-type drift region, a body region, a base region, a source region, a collector region, a field stop region, a pillar region, a buffer region, a recombination promoting region, or an embedded region.

The insulating film formation step S23 is a step of forming the insulating film 52. As an example, the insulating film 52 includes one or more of a gate insulating film, an interlayer insulating film for element isolation, and a cap layer for adjusting a flat band voltage or the like in a gate electrode.

The electrode formation step S24 is a step of forming the electrode 53 for functioning as a semiconductor device. Examples of the electrode 53 include one or more of a gate electrode 531, a source electrode 532, a drain electrode 533, a base electrode, an emitter electrode, a collector electrode, an anode electrode, a cathode electrode, an ohmic electrode, and a Schottky electrode.

The device formation step S20 may further include a removal step S25 of removing at least a part of the bulk layer 10. As described above, by removing a part or the whole of the bulk layer 10, it is possible to reduce a thickness of the bulk layer 10 which is a conductive layer and contribute to reduction of on-resistance. The removal step S25 can be adopted as long as it is a method for reducing the thickness of the bulk layer 10, and a known grinding method, polishing method, etching method, and the like can be exemplified.

### <<Silicon carbide semiconductor device>>

The silicon carbide semiconductor device according to the present invention is semiconductor devices 200 and 201 manufactured using the method for reducing the stacking faults of silicon carbide described above, and includes the epitaxial layer 20 in which the stacking faults SF are converted into the crystal defects other than the stacking faults SF. Note that constituent elements that are basically the same as the constituent elements described in the previous embodiments are denoted by the same reference numerals, and the description thereof will be simplified.

As illustrated in Fig. 4, a silicon carbide semiconductor device 200 according to the embodiment includes one epitaxial layer 20 obtained by converting the stacking faults SF in the bulk layer 10 into the crystal defects other than the stacking faults SF, and the device region 50 formed in epitaxial layer 20.

The density of the stacking faults of the epitaxial layer 20 is preferably 5.0 faults/cm² or less, more preferably 3.0 faults/cm² or less, and still more preferably 1.0 faults/cm² or less.

In addition, as illustrated in Fig. 5, a silicon carbide semiconductor device 201 according to another embodiment includes the first epitaxial layer 21 obtained by converting the stacking faults SF of the bulk layer 10 into the crystal defects other than the stacking faults SF, the second epitaxial layer 22 having a doping concentration lower than that of the bulk layer 10, and the device region 50 formed in the second epitaxial layer 22.

The density of stacking faults SF of the second epitaxial layer 22 is preferably 5.0 faults/cm² or less, more preferably 3.0 faults/cm² or less, and still more preferably 1.0 faults/cm² or less.

In the silicon carbide semiconductor devices 200 and 201 according to these embodiments, the device region is formed in the epitaxial layer in which the stacking faults SF are suppressed. Therefore, it is possible to suppress the above-described problems such as (1) generating the interface state under the gate oxide film in the SiC-MOSFET to destabilize the gate threshold voltage, (2) causing bipolar deterioration in the SiC-MOSFET and the PiN diode, (3) increasing the on-resistance in the SiC-MOSFET, and (4) generating the leakage current between the drain and source (DS) in the SiC-MOSFET.

Note that the silicon carbide semiconductor devices 200 and 201 according to the embodiments include, for example, a Schottky barrier diode, a junction barrier Schottky diode, a thyristor, a bipolar junction transistor, and a PiN diode.

### Examples

Hereinafter, the present invention will be described more specifically based on the examples and comparative examples. Note that the present invention is not limited to the following contents.

An apparatus used in the following examples is an apparatus described in Patent Literature 2, and includes the main container 30, the refractory material container 40, and a heating furnace that accommodates the main container 30 and the refractory material container 40 and is capable of heating to form the temperature gradient.

In addition, the CVD apparatus used in the following examples and comparative examples is an apparatus having a general structure used in the thermal CVD method, and includes a susceptor that generates heat by induction heating, a heating induction coil that heats the susceptor, a gas introduction unit that introduces a source gas (a hydrocarbon source gas, a silicon source gas, and a doping gas and a carrier gas such as a hydrogen gas), and a gas exhaust unit that exhausts gases after being used for epitaxial growth.

In Example 1 and Comparative Example 1, a silicon carbide substrate manufactured by a company A was used, in Example 2 and Comparative Example 2, a silicon carbide substrate manufactured by a company B was used, in Example 3 and Comparative Example 3, a silicon carbide substrate manufactured by a company C was used, and in Example 4, a silicon carbide substrate manufactured by a company D was used. Any of the substrates was inclined by 4 degrees in a <11-20> direction with a diameter of 6 inches.

### <Example 1>

The first growth step S11 of growing the first epitaxial layer 21 under the SiC-C equilibrium vapor pressure environment was performed on the silicon carbide substrate manufactured by the company A. Thereafter, on the substrate on which the first epitaxial layer 21 had been grown, the second growth step S12 of growing the second epitaxial layer 22 using a CVD apparatus was performed. Each epitaxial layer was grown on a (0001) plane (= Si plane).

### (First growth step S11)

In the first growth step S11, the silicon carbide substrate was accommodated in the main container 30, and the main container 30 was accommodated in the refractory material container 40 and heated to 1800°C using the heating furnace.

As the main container 30, a container made of the polycrystalline SiC was used. The atomic ratio Si/C in the main container 30 in which the silicon carbide substrate was disposed was 1. Specifically, since the silicon carbide substrate satisfying the stoichiometric ratio 1:1 was disposed in the main container 30 made of the polycrystalline SiC satisfying the stoichiometric ratio 1:1, the atomic ratio Si/C in the main container 30 was 1. As described above, the first epitaxial layer 21 was grown on the bulk layer 10 in the SiC-C equilibrium vapor pressure environment by heating the main container 30 in which the atomic ratio Si/C in the container was 1.

As the refractory material container 40, a container made of TaC having a tantalum silicide layer on an inner side was used. In other words, the Si vapor pressure environment in the refractory material container 40 was formed by heating the tantalum silicide layer and supplying Si vapor into the refractory material container 40.

### (Second growth step S12)

On the substrate on which the first epitaxial layer 21 had been grown, the second growth step S12 of growing the second epitaxial layer 22 using the thermal CVD method was performed. The substrate was placed on the susceptor and heated to 1650°C. Then, epitaxial growth was performed for 30 minutes with a supply amount of propane of 20 cc/min, a supply amount of silane of 100 cc/min, a supply amount of nitrogen as a doping gas of 5 cc/min, and a supply amount of hydrogen as a carrier gas of 100 liters/min. Since the propane contained 3 carbons in one molecule, the C/Si ratio here was 20 × 3/100 = 0.6.

A silicon carbide substrate according to Example 1 was obtained through the first growth step S11 and the second growth step S12 described above. Next, in order to evaluate the stacking faults SF in the obtained second epitaxial layer 22, photoluminescence measurement was performed. As a result, the density of stacking faults SF of the second epitaxial layer 22 obtained in Example 1 was 2.0 faults/cm⁻².

The growth conditions of the second growth step S12 described above are considered to be conditions under which the epitaxial layer grows while taking over the stacking faults SF of the lower layer. Therefore, the density of stacking faults SF of the first epitaxial layer 21 obtained in Example 1 is considered to be equivalent to 2.0 faults/cm⁻².

### <Comparative Example 1>

On the same silicon carbide substrate manufactured by the company A as in Example 1, an epitaxial layer was formed by performing the second growth step S12 under the same conditions as in Example 1 without performing the first growth step S11, and thus a silicon carbide substrate according to Comparative Example 1 was obtained. The epitaxial layer was grown on the (0001) plane (= Si plane) of the bulk layer 10.

In order to evaluate the stacking faults SF in the obtained epitaxial layer, the photoluminescence measurement was performed under the same conditions as in Example 1. As a result, density of the stacking faults of the epitaxial layer obtained in Comparative Example 1 was 20.8 faults/cm⁻².

As described above, the growth conditions of the second growth step S12 are considered to be conditions for growing the epitaxial layer by taking over the stacking faults SF of the lower layer. Therefore, the density of stacking faults SF of the bulk layer 10 manufactured by the company A is considered to be equivalent to 20.8 faults/cm-2

A comparison between Example 1 and Comparative Example 1 shows that Example 1 includes a growth step of growing the epitaxial layer under the SiC-C equilibrium vapor pressure environment, thereby significantly reducing the density of stacking faults SF.

In particular, it is considered that the density of stacking faults SF is reduced to 2.0 faults/cm⁻² by performing the first growth step S11 on the bulk layer 10 in which the density of stacking faults SF is considered to be 20.8 faults/cm⁻², under the SiC-C equilibrium vapor pressure environment. The conversion rate of the stacking faults SF in the first epitaxial layer 21 at this time is considered to be equal to (1 -2.0/20.8) × 100 = 90.3%.

In other words, according to Example 1, the growth step S10 is a step capable of growing an epitaxial layer having a density of stacking faults of 3.0 faults/cm² or less on a 6-inch bulk layer having a density of stacking faults SF of 10.0/cm² or more.

### <Example 2>

The silicon carbide substrate manufactured by the company B was subjected to the first growth step S11 and the second growth step S12 under the same conditions as in Example 1 to obtain a silicon carbide substrate according to Example 2. The epitaxial layer was grown on the (0001) plane (= Si plane).

In order to evaluate the stacking faults SF in the obtained epitaxial layer 20, the photoluminescence measurement was performed under the same conditions as in Example 1. As a result, the density of stacking faults SF of the second epitaxial layer 22 obtained in Example 2 was 2.5 faults/cm⁻².

The growth conditions of the second growth step S12 described above are considered to be conditions under which the epitaxial layer grows while taking over the stacking faults SF of the lower layer. Therefore, the density of stacking faults SF of the first epitaxial layer 21 obtained in Example 2 is considered to be equivalent to 2.5 faults/cm⁻².

### <Comparative Example 2>

On the same silicon carbide substrate manufactured by the company B as in Example 2, an epitaxial layer was formed by performing the second growth step S12 under the same conditions as in Example 2 without performing the first growth step S11, and thus a silicon carbide substrate according to Comparative Example 2 was obtained. The epitaxial layer was grown on the (0001) plane (= Si plane) of the bulk layer 10.

In order to evaluate the stacking faults SF of the obtained epitaxial layer, the photoluminescence measurement was performed under the same conditions as in Example 2. As a result, the density of the stacking faults of the epitaxial layer obtained in Comparative Example 2 was 5.9 faults/cm⁻².

As described above, the growth conditions of the second growth step S12 are considered to be conditions for growing the epitaxial layer by taking over the stacking faults SF of the lower layer. Therefore, the density of stacking faults SF of the bulk layer 10 manufactured by the company B is considered to be equivalent to 5.9 faults/cm⁻².

A comparison between Example 2 and Comparative Example 2 shows that Example 2 includes a growth step of growing the epitaxial layer under the SiC-C equilibrium vapor pressure environment, thereby significantly reducing the density of stacking faults SF.

In particular, it is considered that the density of stacking faults SF is reduced to 2.5 faults/cm⁻² by performing the first growth step S11 on the bulk layer 10 in which the density of stacking faults SF is considered to be 5.9 faults/cm⁻², under the SiC-C equilibrium vapor pressure environment. The conversion rate of the stacking faults SF in the first epitaxial layer 21 at this time is considered to be equal to (1 -2.5/5.9) × 100 = 57.6%.

In other words, according to Example 2, the growth step S10 is a step capable of growing an epitaxial layer having a density of stacking faults of 3.0 faults/cm² or less on a 6-inch bulk layer having a density of stacking faults SF of 5.0/cm² or more.

### <Example 3>

The first growth step S11 and the second growth step S12 were performed on the silicon carbide substrate manufactured by the company C under the same conditions as in Example 1 and Example 2 to obtain a silicon carbide substrate according to Example 3. The epitaxial layer was grown on the (0001) plane (= Si plane).

In order to evaluate the stacking faults SF in the obtained epitaxial layer 20, the photoluminescence measurement was performed under the same conditions as in Example 1. As a result, the density of stacking faults SF in the second epitaxial layer 22 obtained in Example 3 was 2.1 faults/cm⁻².

The growth conditions of the second growth step S12 described above are considered to be conditions under which the epitaxial layer grows while taking over the stacking faults SF of the lower layer. Therefore, the density of stacking faults SF of the first epitaxial layer 21 obtained in Example 3 is considered to be equivalent to 2.1 faults/cm⁻².

### <Comparative Example 3>

On the same silicon carbide substrate manufactured by the company C as in Example 3, an epitaxial layer was formed by performing the second growth step S12 under the same conditions as in Example 3 without performing the first growth step S11, and thus a silicon carbide substrate according to Comparative Example 3 was obtained. The epitaxial layer was grown on the (0001) plane (= Si plane) of the bulk layer 10.

In order to evaluate the stacking faults SF in the obtained epitaxial layer, the photoluminescence measurement was performed under the same conditions as in Example 3. As a result, the density of the stacking faults of the epitaxial layer obtained in Comparative Example 3 was 6.9 faults/cm⁻².

As described above, the growth conditions of the second growth step S12 are considered to be conditions for growing the epitaxial layer by taking over the stacking faults SF of the lower layer. Therefore, the density of stacking faults SF in the bulk layer 10 manufactured by the company C is considered to be equivalent to 6.9 faults/cm⁻².

A comparison between Example 3 and Comparative Example 3 shows that Example 3 includes a growth step of growing the epitaxial layer under the SiC-C equilibrium vapor pressure environment, thereby significantly reducing the density of stacking faults SF.

In particular, it is considered that the density of stacking faults SF is reduced to 2.1 faults/cm⁻² by performing the first growth step S11 on the bulk layer 10 in which the density of stacking faults SF is considered to be 6.9 faults/cm⁻², under the SiC-C equilibrium vapor pressure environment. The conversion rate of the stacking faults SF in the first epitaxial layer 21 at this time is considered to be equal to (1 -2.1/6.9) × 100 = 69.5%.

In other words, according to Example 3, the growth step S10 is a step capable of growing an epitaxial layer having a density of stacking faults of 3.0 pieces/cm² or less on a 6-inch bulk layer having a density of stacking faults SF of 5.0/cm² or more.

### <Example 4>

A silicon carbide substrate according to Example 4 was obtained by performing the first growth step S11 and the second growth step S12 on a silicon carbide substrate manufactured by the company D under the same conditions as in Example 1. The epitaxial layer was grown on the (0001) plane (= Si plane).

In order to evaluate the stacking faults SF in the obtained epitaxial layer 20, the photoluminescence measurement was performed under the same conditions as in Example 1. As a result, the density of stacking faults SF of the second epitaxial layer 22 obtained in Example 4 was 0.7 faults/cm⁻².

The growth conditions of the second growth step S12 described above are considered to be conditions under which the epitaxial layer grows while taking over the stacking faults SF of the lower layer. Therefore, the density of stacking faults SF in the first epitaxial layer 21 obtained in Example 4 is considered to be equivalent to 0.7 faults/cm⁻².

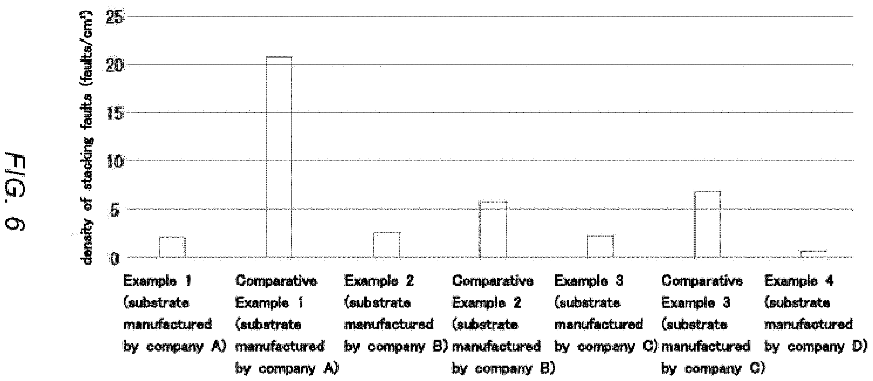

The density of stacking faults SF of each of Example 1, Comparative Example 1, Example 2, Comparative Example 2, Example 3, Comparative Example 3, and Example 4 is shown in Fig. 6. As can be seen from Fig. 6, by using the method for reducing the stacking faults SF in silicon carbide according to the present invention, a silicon carbide substrate in which the density of stacking faults SF is reduced can be manufactured. In particular, although substrates from multiple different companies A, B, and C were adopted, the epitaxial layers in which the density of stacking faults SF was 3.0 faults/cm⁻² or less were obtained in all the substrates.

In other words, according to the present invention, by including the step of growing under the SiC-C equilibrium vapor pressure environment, a substrate having a density of stacking faults SF of 3.0 faults/cm⁻² or less can be obtained by two steps of growing the first epitaxial layer 21 and the second epitaxial layer 22. Furthermore, according to Example 4, it is possible to obtain a substrate in which the density of stacking faults SF of the second epitaxial layer 22 is 1.0 faults/cm⁻² or less.

The growth conditions of the second growth step S12 are considered to be conditions under which the epitaxial layer grows while taking over the stacking faults SF of the lower layer. Therefore, the density of stacking faults SF of the first epitaxial layer 21 of Examples 1 to 4 is considered to be 3.0 faults/cm⁻² or less.

In other words, it is suggested that a substrate having a density of stacking faults SF of the epitaxial layer of 3.0 faults/cm⁻² or less can be obtained through one step of growing the first epitaxial layer 21. Furthermore, according to Example 4, it is suggested that a substrate in which the density of stacking faults SF of the first epitaxial layer 21 is 1.0 defects/cm⁻² or less can be obtained.

By manufacturing a semiconductor device using a silicon carbide substrate in which the stacking faults SF are reduced as described above, at least one of the following problems of a conventional semiconductor device can be solved: (1) generating the interface state under the gate oxide film in the SiC-MOSFET to destabilize the gate threshold voltage; (2) causing bipolar degradation in the SiC-MOSFET or the PIN diode; (3) increasing the on-resistance in the SiC-MOSFET; and (4) generating the leakage current between the drain and source (DS) in the SiC-MOSFET.

### Reference Signs List

- 100, 101: Silicon carbide substrate
- 200, 201: Silicon carbide semiconductor device
- 10: Bulk layer
- 20: Epitaxial layer
- 21: First epitaxial layer
- 22: Second epitaxial layer
- 30: Main container
- 31: Upper container
- 32: Lower container
- 33: Gap
- 40: Refractory material container
- 41: Upper container
- 42: Lower container
- 43: Gap
- 44: Si vapor supply source
- 50: Device region
- 51: Doping region
- 52: Insulating film
- 53: Electrode
- S10: Growth step
- S11: First growth step
- S12: Second growth step
- S20: Device formation step

## Claims

1. A method for reducing stacking faults in silicon carbide, the method comprising a growth step of growing an epitaxial layer on a bulk layer having stacking faults under a SiC-C equilibrium vapor pressure environment.

2. The method according to claim 1, wherein the growth step comprises a first growth step of growing a first epitaxial layer under the SiC-C equilibrium vapor pressure environment; and
a second growth step of growing a second epitaxial layer on the first epitaxial layer.

3. The method according to claim 1 or 2, wherein the growth step is a step of growing the epitaxial layer having a density of the stacking faults of 5.0 faults/cm² or less.

4. The method according to claim 1 or 2, wherein the growth step is a step of growing the epitaxial layer having a density of the stacking faults of 3.0 faults/cm² or less.

5. The method according to claim 1 or 2, wherein the growth step is a step of growing the epitaxial layer having a density of the stacking faults of 1.0 faults/cm² or less.

6. The method according to any one of claims 1 to 5, wherein the growth step is a step of growing the epitaxial layer on the bulk layer having a diameter of at least 4 inches or more.

7. A method for manufacturing a silicon carbide substrate using the method according to any one of claims 1 to 6.

8. A silicon carbide substrate manufactured by the method according to claim 7, wherein
a density of stacking faults in the epitaxial layer is 5.0 faults/cm² or less.

9. A silicon carbide substrate comprising one epitaxial layer in which stacking faults are converted into crystal defects other than the stacking faults, wherein
the epitaxial layer has a density of stacking faults of 5.0 faults/cm² or less.

10. A silicon carbide substrate comprising:
a first epitaxial layer in which stacking faults are converted into crystal defects other than the stacking faults; and
a second epitaxial layer grown on the first epitaxial layer, wherein
a density of stacking faults of the second epitaxial layer is 5.0 faults/cm² or less.

11. The substrate according to any one of claims 8 to 10, wherein the density of the stacking faults is 3.0 faults/cm² or less.

12. The substrate according to any one of claims 8 to 10, wherein the density of the stacking faults is 1.0 faults/cm² or less.

13. The substrate of any one of claims 8 to 12, wherein the substrate has a diameter of at least 4 inches or more.

14. A method for manufacturing a silicon carbide semiconductor device using a silicon carbide substrate having an epitaxial layer grown by the method according to any one of claims 1 to 6, the method comprising:
a device formation step of forming a device region in at least a part of the substrate.

15. A silicon carbide semiconductor device manufactured by the method according to claim 14, wherein
a density of the stacking faults in the epitaxial layer is 5.0 faults/cm² or less.

16. A silicon carbide semiconductor device comprising:
one epitaxial layer in which stacking faults are converted into crystal defects other than the stacking faults; and
a device region formed in the epitaxial layer, wherein
a density of the stacking faults in the epitaxial layer is 5.0 faults/cm² or less.

17. A silicon carbide semiconductor device comprising:
a first epitaxial layer in which stacking faults are converted into crystal defects other than the stacking faults;
a second epitaxial layer grown on the first epitaxial layer; and
a device region formed in the second epitaxial layer, wherein
a density of stacking faults in the second epitaxial layer is 5.0 faults/cm² or less.

18. The semiconductor device according to any one of claims 15 to 17, wherein the density of the stacking faults is 3.0 faults/cm² or less.

19. The semiconductor device according to any one of claims 15 to 17, wherein the density of the stacking faults is 1.0 faults/cm² or less.
